# EUROPÄISCHE PATENTSCHRIFT

(11) **EP 3 189 533 B1**
(45) Veröffentlichungstag und Bekanntmachung des Hinweises auf die Patenterteilung: **07.04.2021**
(21) Anmeldenummer: 15738296.1
(22) Anmeldetag: 08.07.2015
(51) Int. Cl.: H01G 2/04, H01G 2/06, H05K 3/30

(54) **SCHWINGUNGSFESTE ELEKTRONIKBAUTEILANORDNUNG**
VIBRATION RESISTANT ELECTRONIC COMPONENT ASSEMBLY
ENSEMBLE À COMPOSANT ÉLECTRONIQUE RÉSISTANT AUX VIBRATIONS

(30) Priorität: 03.09.2014 DE 102014217596
(43) Veröffentlichungstag der Anmeldung: 12.07.2017
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2015/065600
(87) Internationale Veröffentlichungsnummer: WO 2016/034312

(56) Entgegenhaltungen:
- WO-A1-2009/010704
- WO-A1-2013/006103
- DE-A1- 10 034 012
- DE-U1-202007 004 496
- US-A- 6 163 460

## Beschreibung

### Gebiet der Erfindung

Die Erfindung betrifft eine Elektronikbauteilanordnung zur schwingungsfesten Montage eines elektronischen Bauteils, insbesondere eines Elektrolytkondensators.

### Hintergrund der Erfindung

Häufig sind elektronische Bauteile erhöhten mechanischen Belastungen ausgesetzt, etwa aufgrund von Vibrationen und/oder Schwingungen in einem Kraftfahrzeug oder in anderen elektromechanischen Vorrichtungen. Dadurch kann eine Lebensdauer des Bauteils beeinträchtigt sein.

Insbesondere betrifft dies Elektrolytkondensatoren, welche häufig auf Leitblechen, Leiterplatten und/oder Stanzgittern elektrisch kontaktiert und z.B. als Entstörkondensatoren in Entstörbaugruppen eingesetzt werden, beispielsweise bei bürstenlosen Gleichstrommotoren (BLDC-Motoren), in einer Getriebesteuerung, in einer elektrischen Lenkung eines Kraftfahrzeugs oder in anderen Elektroniken.

Grundsätzlich können viele elektronische Bauteile zur Sicherstellung einer ausreichenden Schwingungsfestigkeit zumindest teilweise in einer Vergussmasse vergossen und/oder verklebt werden. Dies kann jedoch mit erhöhten Produktionskosten für die Vergussmasse, einen Klebstoff und/oder einen entsprechenden Aushärteprozess verbunden sein.

Insbesondere Elektrolytkondensatoren können häufig nicht vollständig vergossen werden, da derartige Bauteile während des Betriebes ein Gas produzieren können, etwa Wasserstoffgas, welches aus dem Bauteil entweichen können sollte, da ein ansonsten potentiell auftretender Überdruck Komponenten des Bauteils schädigen kann.

Aus der DE 10 2011 004 142 A1 ist eine Abdichtung für ein Bauelement, aus welchem Gas austreten kann, bekannt. Die Abdichtung weist eine Dichtungsmanschette mit einem dünnwandigen, eine Gasdiffusion ermöglichenden Bereich auf.

Elektronikbauteilanordnungen mit Anschlussdrähten und diese elektrische kontaktierende Kontaktgabeln werden in der WO 2009/010704 A1, in der US 6 163 460 A, in der WO 2013/006103 A1 sowie in der DE 100 34 012 A1 und der DE 20 2007 004496 U1 beschrieben.

### Offenbarung der Erfindung

Ausführungsformen der vorliegenden Erfindung können in vorteilhafter Weise ermöglichen, eine zuverlässige, robuste und mechanisch belastbare Elektronikbauteilanordnung mit einem elektronischen Bauteil, insbesondere einem Elektrolytkondensator, bereitzustellen.

Gemäß einem Aspekt der Erfindung wird eine Elektronikbauteilanordnung vorgeschlagen, welche ein elektronisches Bauteil mit einem Bauteilkörper undzwei Anschlussdrähten aufweist, welche von einer Seite des Bauteilkörpers abragen. Weiter weist die Elektronikbauteilanordnung zwei Kontaktgabeln zur elektrischen Kontaktierung jeweils eines Anschlussdrahtes auf. Eine Fixiervorrichtung zur Fixierung der Anschlussdrähte ist zwischen den Kontaktgabeln und dem Bauteilkörper angeordnet, wobei ein erstes Ende der Fixiervorrichtung auf einer Trägerplatte befestigt ist und ein zweites Ende der Fixiervorrichtung von der Trägerplatte abragt. An dem zweiten Ende ist jeweils eine Aussparung angeordnet, in welcher jeweils ein Anschlussdraht aufgenommen und positionssicher fixiert ist. Die beiden Kontaktgabeln zur elektrischen Kontaktierung des jeweiligen Anschlussdrahtes ragen auf der Trägerplatte parallel zueinander im Wesentlichen orthogonal von der Trägerplatte ab.

Die Fixiervorrichtung kann als eine Art Führung bzw. Führungsvorrichtung für den Anschlussdraht erachtet werden. Durch die erfindungsgemäße Anordnung der Fixiervorrichtung zwischen der Kontaktgabel und dem Bauteilkörper sowie durch die Fixierung des Anschlussdrahtes in der Aussparung kann sichergestellt sein, dass der Anschlussdraht zumindest vom Bauteilkörper bis zur Fixiervorrichtung ohne mechanische Vorspannung, auch Mittelspannung genannt, aus dem Bauteilkörper geführt werden kann. Dadurch kann ein elektrischer Kontakt zwischen dem Anschlussdraht und Komponenten in einem Inneren des Bauteilkörpers ohne mechanische Vorspannung bereitgestellt werden, so dass der elektrische Kontakt dynamischen Belastungen, wie etwa Schwingungen und/oder Vibrationen, zuverlässig standhalten kann. Somit kann in vorteilhafter Weise eine Schwingungsfestigkeit des Bauteils maximal ausgenutzt und/oder erhöht werden. Ferner können gegenüber Elektronikbauteilanordnungen, in denen das Bauteil zum Schutz gegen dynamische Belastungen zumindest teilweise vergossen und/oder verklebt ist, Produktionskosten gesenkt werden.

Auch kann die erfindungsgemäße Elektronikbauteilanordnung einfach im Design umgesetzt und einfach als zusätzlicher Prozessschritt in eine Fertigung integriert werden.

Ideen zu Ausführungsformen der vorliegenden Erfindung können unter anderem als auf den nachfolgend beschriebenen Gedanken und Erkenntnissen beruhend angesehen werden. Elektrolytkondensatoren werden in der Regel in einem Klebstoffbett und/oder einer Vergussmasse auf einer Trägerplatte fixiert und an Kontaktgabeln eines Stanzgitters elektrisch kontaktiert, beispielsweise durch Hotstacking oder Widerstandsschweißen. Elektrolytkondensatoren weisen meist einen im Bauteilkörper angeordneten und mit einem Elektrolyt getränkten Wickel und einer Folie auf, welche mit so genannten Paddle-Tabs, etwa mittels Nietung oder Verklinkung, elektrisch kontaktiert ist. Aufgrund möglicher Montage- und/oder Bauteiltoleranzen fluchtet der Anschlussdraht bisweilen nicht exakt mit der Kontaktgabel des Stanzgitters. Wird die Kontaktgabel nun durch Hotstacking und/oder Widerstandsschweißen kontaktiert und somit der Anschlussdraht fest geklemmt und/oder geschweißt und elektrisch verbunden, so kann dieser durch die mechanisch steifere Kontaktgabel in eine neue Position gezwungen werden. Da dies eine teilweise elastische Verformung des Anschlussdrahtes ist, kann eine mechanische Vor- bzw. Mittelspannung auf den Anschlussdraht wirken. Ist der Elektrolytkondensator nun im Betrieb Schwingungen und/oder Vibrationen ausgesetzt, so kann eine dynamische Schwingungsbelastung auf diesen wirken. Ein mechanisches Versagen eines elektrischen Kontaktes oder eines elektronischen Bauteils bei Schwingungsbelastung kann stark durch vorhandene statische mechanische Vorspannungen in einem Material und/oder an elektrischen Verbindungsstellen bzw. Kontakten verursacht werden. Beispielsweise kann ein unvorbelastetes Bauteil eine Schwingungsbelastung von 200 m/s² ohne Schädigung überstehen. Steht das Bauteil aber bereits unter einer statischen Vorbelastung, so kann sich die dynamische Belastung auf die statische Belastung addieren und das Bauteil kann versagen. Diese Zusammenhänge können in der Festigkeitslehre in einem sogenannten Haigh-Diagramm dargestellt werden. Demnach kann eine Schwingungsfestigkeit eines Systems mit einem Mittelspannungsniveau größer Null rapide absinken, wenn eine Schwingungsbelastung auf das System wirkt. Die Schwingungsfestigkeit kann somit maximiert werden, wenn sich das System in einem mechanisch spannungsfreien Zustand befindet, d.h. die mechanische Mittelspannung Null ist.

Durch die erfindungsgemäße Führung des Anschlussdrahtes durch die Aussparung der Fixiervorrichtung sowie dessen Fixierung darin kann beispielsweise bei einem Elektrolytkondensator erreicht werden, dass eine mögliche Verformung des Anschlussdrahtes durch Kontaktieren mit der Kontaktgabel nicht bis zu den Paddle-Tabs geleitet wird, weshalb sich diese in einem mechanisch spannungsfreien Zustand befinden können und so insbesondere die Nietung oder Verklinkung des Paddle-Tabs mit der Folie des Wickels vor einem Versagen geschützt werden kann, weil eine dynamische Schwingungsbelastung auf den Wickel ohne Mittelspannungsbelastung erfolgen kann.

Gemäß einer Ausführungsform der Erfindung ist ein Querschnitt der Aussparung wesentlich größer als ein Querschnitt des Anschlussdrahtes. Ein verhältnismäßig großer Querschnitt der Aussparung kann insbesondere eine Fertigung vereinfachen, da der Anschlussdraht leicht, spannungsfrei und ohne zusätzliches Werkzeug in der Aussparung positioniert und fixiert werden kann.

Gemäß einer Ausführungsform der Erfindung ist ein Querschnitt der Aussparung wenigstens doppelt so groß ist wie ein Querschnitt des Anschlussdrahtes. Der Querschnitt der Aussparung kann dabei einen maximalen Querschnitt der Aussparung bezeichnen. Der Querschnitt der Aussparung kann beispielsweise wenigstens 10% größer, vorzugsweise wenigstens 30% größer, als der Querschnitt des Anschlussdrahtes sein. Dadurch kann sichergestellt sein, dass der Anschlussdraht berührungsfrei und somit spannungsfrei in der Aussparung positioniert und fixiert werden kann.

Gemäß einer Ausführungsform der Erfindung weisen zwei sich planparallel gegenüberliegende Begrenzungsflächen der Aussparung wenigstens einen Abstand eines 1,3-fachen Wertes eines Durchmessers des Anschlussdrahtes auf. Der Abstand der beiden Begrenzungsflächen kann eine maximale Breite der Aussparung bezeichnen. Die Aussparung kann beispielsweise eine Breite von wenigstens dem zweifachen, vorzugsweise wenigstens dem dreifachen Wert des Durchmessers des Anschlussdrahtes aufweisen. Dadurch kann der Anschlussdraht unter allen Toleranzbedingungen berührungsfrei, spannungsfrei und reibungsfrei in der Aussparung positioniert und fixiert werden.

Gemäß einer Ausführungsform der Erfindung besteht die Fixiervorrichtung aus Kunststoff. Die Fixiervorrichtung kann einteilig mit der Trägerplatte ausgebildet sein. Die Fixiervorrichtung kann auch als separates Bauteil auf der Trägerplatte angeordnet und fixiert sein, beispielsweise kann sie auf die Trägerplatte geklebt sein.

Gemäß einer Ausführungsform der Erfindung ist der Anschlussdraht mit einer Fixiermasse in der Aussparung fixiert. Die Fixiermasse kann beispielsweise ein Klebstoff, eine Vergussmasse und/oder ein zähflüssiger Lack sein. Genauer kann die Fixiermasse etwa eine Epoxidharzmasse, eine Polyurethanmasse, eine Polyurethan-Epoxidharzmasse und/oder eine Silikonvergussmasse sein. Die Fixiermasse kann ferner beispielsweise thermisch-härtend, licht-härtend, chemisch-härtend und/oder trocknungs-härtend sein. Insgesamt kann die Fixiermasse hinsichtlich ihrer Viskosität derart eingestellt sein, dass sie während einer Fertigung der Elektronikbauteilanordnung nicht schwerkraftsbedingt aus der Aussparung läuft. Insgesamt kann eine Fixierung des Anschlussdrahtes mit der Fixiermasse in einem einfachen und schnell durchführbaren Prozessschritt erfolgen, ohne dass teure Spezialwerkzeuge nötig sind. Dadurch können auch Produktionskosten gesenkt werden.

Gemäß einer Ausführungsform der Erfindung ist die Aussparung in Richtung einer Flächennormalen der Trägerplatte offen ausgebildet ist. Mit anderen Worten kann die Aussparung an einer der Trägerplatte gegenüberliegenden Außenseite der Fixiervorrichtung offen ausgebildet sein. Beispielsweise kann die Aussparung V-förmig oder U-förmig ausgebildet sein bzw. einen V-förmigen oder U-förmigen Querschnitt aufweisen. So kann der Anschlussdraht orthogonal zu dessen Längserstreckungsrichtung in der Aussparung angeordnet werden und die Aussparung kann leicht, schnell und zuverlässig mit Fixiermasse befüllt werden.

Gemäß einer Ausführungsform der Erfindung ist die Aussparung als ringförmig geschlossene Durchgangsöffnung an dem zweiten Ende der Fixiervorrichtung ausgebildet ist. Die Durchgangsöffnung kann einen beliebigen Querschnitt aufweisen, beispielsweise einen runden, einen dreieckigen, einen viereckigen, einen trapezförmigen oder einen polygonartigen.

Gemäß einer Ausführungsform der Erfindung weist das elektronische Bauteil wenigstens zwei Anschlussdrähte auf, welche jeweils von der gleichen Seite des Bauteilkörpers abragen, wobei die Fixiervorrichtung zwei Aussparungen aufweist, in welchen jeweils ein Anschlussdraht aufgenommen ist. Durch eine Aufnahme jeweils eines Anschlussdrahtes in einer Aussparung kann beispielsweise ein Kurzschluss zwischen den beiden Anschlussdrähten vermieden werden.

Gemäß einer Ausführungsform der Erfindung ist das elektronische Bauteil ein Elektrolytkondensator. Der Elektrolytkondensator kann etwa einen in dem Bauteilkörper angeordneten sowie mit einer Folie und einem Elektrolyt versehenen Wickel aufweisen. Der Elektrolytkondensator kann ferner einen zumindest teilweise gasdurchlässigen Stopfen aufweisen, welcher stirnseitig in einer Öffnung des Bauteilkörpers aufgenommen sein kann, wobei der Anschlussdraht mit einem Ende mit der Folie des Wickels elektrisch verbunden sein kann.

Es wird darauf hingewiesen, dass einige der möglichen Merkmale und Vorteile der Erfindung hierin mit Bezug auf unterschiedliche Ausführungsformen beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
Fig. 1 zeigt eine Seitenansicht einer Elektronikbauteilanordnung gemäß einer Ausführungsform der Erfindung.
Fig. 2 zeigt eine Frontansicht der Elektronikbauteilanordnung aus Fig. 1 entlang der Linie A-A.
Fig. 3 zeigt ein Schnittbild der Elektronikbauteilanordnung der Fig. 1 und 2.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

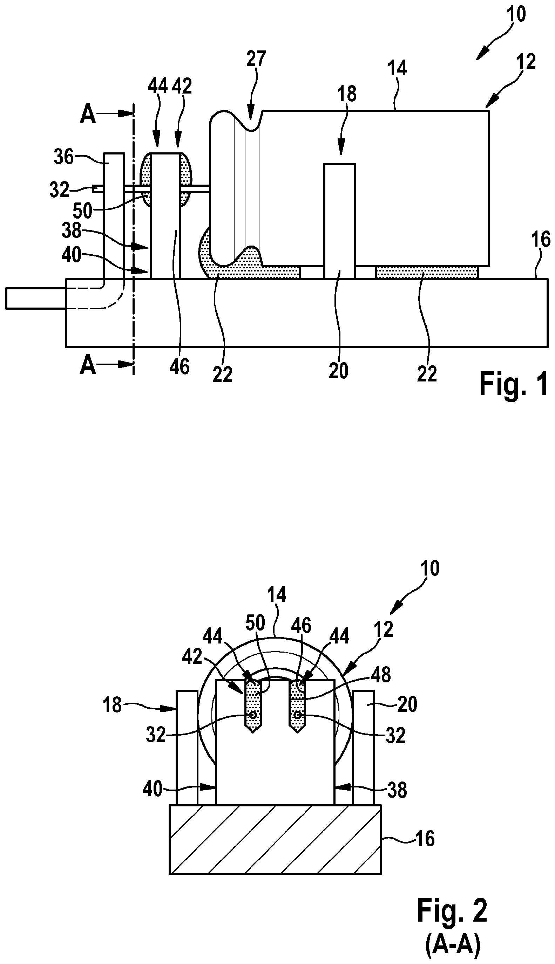

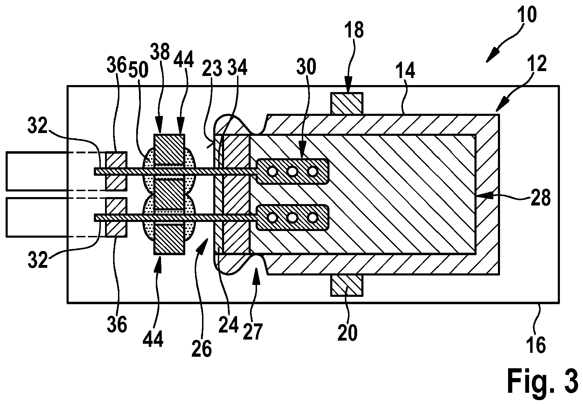

Fig. 1 zeigt eine Seitenansicht einer Elektronikbauteilanordnung 10 gemäß einer Ausführungsform der Erfindung. Fig. 2 zeigt eine Frontansicht der Elektronikbauteilanordnung 10 aus Fig. 1 entlang der Linie A-A. Fig. 3 zeigt ein Schnittbild der Elektronikbauteilanordnung 10 der Fig. 1 und 2.

Die Elektronikbauteilanordnung 10 weist ein elektronisches Bauteil 12 mit einem im Wesentlichen zylindrischen Bauteilkörper 14 auf. Das Bauteil 12 kann etwa ein Elektrolytkondensator sein.

Der Bauteilkörper 14 ist auf einer Trägerplatte 16 angeordnet, auf welcher eine Haltevorrichtung 18 zur Fixierung des Bauteilkörpers 14 angeordnet ist. Die Haltevorrichtung 18 weist dabei zwei sich gegenüberliegende Klemmabragungen 20 auf, zwischen welchen der Bauteilkörper 14 angeordnet ist und welche den Bauteilkörper 14 an zwei sich gegenüberliegenden Teilflächen einer Mantelfläche des Bauteilkörpers 14 klammerartig zumindest teilweise umgreifen. Die Klemmabragungen 20 können jeweils einen Schnapphaken und eine an der Mantelfläche des Bauteilkörpers 14 anliegende Anschlagfläche aufweisen, so dass der Bauteilkörper 14 in die Haltevorrichtung 18 eingeklipst werden kann und in allen drei Raumrichtungen mechanisch fixiert sein kann. Zusätzlich kann der Bauteilkörper 14 mit einer Verklebung 22 auf der Trägerplatte 16 fixiert sein.

Das elektronische Bauteil 12 weist ferner an einer Stirnseite 23 einen Stopfen 24 auf, welcher zumindest teilweise in einer Öffnung 26 des Bauteilkörpers 14 aufgenommen ist und welcher zumindest teilweise durch eine Verjüngung 27 des Bauteilkörpers 14 klemmend gehalten ist.

In einem Inneren des Bauteilkörpers 14 ist ein mit einem Elektrolyt und einer leitfähigen Folie versehener Wickel 28 angeordnet. Der Wickel 28 kann dabei in dem Bauteilkörper 14 fixiert sein oder ohne Fixierung freiliegend in diesem angeordnet sein.

Der Wickel 28 und/oder die Folie des Wickels 28 ist mit zwei Terminals 30 elektrisch kontaktiert. Die Terminals 30 werden häufig auch als "Paddle-Tabs" bezeichnet und können mit dem Wickel 28 beispielsweise vernietet, verklinkt und/oder anderweitig elektrisch kontaktiert sein, etwa gelötet, geschweißt, geklebt.

An einem Ende der Terminals 30 ist jeweils ein Anschlussdraht 32 angeordnet, welcher jeweils durch eine in dem Stopfen 24 ausgebildete Führungsöffnung 34 geführt ist. Die Anschlussdrähte 32 ragen somit an der Stirnseite 23 des Bauteilkörpers 14 parallel zu einer Längserstreckungsrichtung desselben von diesem ab.

Weiter weist die Elektronikbauteilanordnung 10 zwei Kontaktgabeln 36 auf, welche parallel zueinander im Wesentlichen orthogonal von der Trägerplatte 16 abragen. Die Kontaktgabeln 36 können etwa Teil eines Leiterbleches, einer Leiterplatte und/oder eines Stanzgitters sein. An den Kontaktgabeln 36 ist jeweils ein Anschlussdraht 32 elektrisch kontaktiert. Dazu kann je ein Anschlussdraht 32 in einer Aufnahme zwischen je zwei Zinken der Kontaktgabeln 36 aufgenommen sein und beispielsweise durch Hotstacking, Schweißen, Löten und/oder Kleben elektrisch mit diesen verbunden sein.

In Längserstreckungsrichtung des Bauteilkörpers 14 ist zwischen der Stirnseite 23 des Bauteilkörpers 14 bzw. einer Außenfläche des Stopfens 24 und den Kontaktgabeln 36 eine Fixiervorrichtung 38 angeordnet. Ein erstes Ende 40 der Fixiervorrichtung 38 ist auf der Trägerplatte 16 angeordnet und ein zweites freitragendes Ende 42 ragt von der Trägerplatte 16 im Wesentlichen orthogonal ab. Die Fixiervorrichtung 38 kann aus Kunststoff gefertigt und einteilig mit der Trägerplatte 16 ausgebildet sein oder als separates Bauteil auf dieser befestigt, beispielsweise geklebt, sein.

Die Fixiervorrichtung 38 kann als Haltevorrichtung für die Anschlussdrähte 32 erachtet werden. Dazu weist die Fixiervorrichtung 38 an dem zweiten Ende 42 zwei Aussparungen 44 auf, in welchen jeweils ein Anschlussdraht 32 geführt und aufgenommen ist. Die Aussparungen 44 der Fixiervorrichtung 38 sind jeweils im Wesentlichen fluchtend mit den Führungsöffnungen 34 des Stopfens 24 angeordnet, so dass die Anschlussdrähte 32 krümmungs- bzw. biegungsfrei und/oder geradlinig durch die Aussparungen 44 geführt sind.

Die Aussparungen 44 sind in einer Richtung einer Flächennormalen der Trägerplatte 16 an dem zweiten Ende 42 der Fixiervorrichtung 38 offen ausgebildet. Ein Querschnitt der Aussparungen 44 ist dabei wesentlich größer als ein Querschnitt der Anschlussdrähte 32. Beispielsweise kann der Querschnitt der Aussparungen 44 wenigstens doppelt so groß wie der Querschnitt der Anschlussdrähte 32 sein, so dass die Anschlussdrähte 32 mit einer gewissen seitlichen Toleranz und beispielsweise berührungsfrei in den Aussparungen 44 aufgenommen sein können. Die Aussparungen 44 weisen in einem dem ersten Ende 40 der Fixiervorrichtung 38 zugewandten Teilbereich einen V-förmigen Querschnitt auf. Weiter weisen die Aussparungen 44 in einem dem zweiten Ende 42 der Fixiervorrichtung zugewandten Teilbereich zwei sich planparallel gegenüberliegende Begrenzungsflächen 46, 48 auf. Ein Abstand der Begrenzungsflächen 46, 48 kann eine maximale Breite der Aussparungen 44 bezeichnen. Die maximale Breite der Aussparungen 44 kann beispielsweise wenigstens den 1,3-fachen Wert, vorzugsweise wenigstens den dreifachen Wert eines Durchmessers der Anschlussdrähte 32 aufweisen. Die Aussparungen 44 können jedoch auch insgesamt einen V-förmigen, U-förmigen, einen rechteckigen, einen trapezförmigen oder polygonartigen Querschnitt aufweisen. Auch können die Aussparungen 44 als ringförmig geschlossene Durchgangsöffnungen in der Fixiervorrichtung 38 ausgebildet sein, wobei die Durchgangsöffnungen einen beliebig geformten Querschnitt aufweisen können, beispielsweis eine runden, einen viereckigen, einen dreieckigen, einen trapezförmigen oder einen polygonartigen.

Weiter sind die Anschlussdrähte 32 mit einer Fixiermasse 50 jeweils positionssicher in den Aussparungen 44 fixiert. Die Fixiermasse 50 kann beispielsweise ein Klebstoff, eine Vergussmasse und/oder ein zähflüssiger Lack sein. Genauer kann die Fixiermasse 50 etwa eine Epoxidharzmasse, eine Polyurethanmasse, eine Polyurethan-Epoxidharzmasse und/oder eine Silikonvergussmasse sein. Die Fixiermasse 50 kann ferner beispielsweise thermisch-härtend, licht-härtend, chemisch-härtend und/oder trocknungs-härtend sein.

Eine Montage der Elektronikbauteilanordnung 10 kann wie nachfolgend beschrieben durchgeführt werden. Das elektronische Bauteil 12 kann in einem ersten Schritt in die Haltevorrichtung 18 eingelegt und/oder eingeklipst werden, wobei der Bauteilkörper 14 optional auf die kurz zuvor auf die Trägerplatte 16 aufgebrachte Verklebung 22 aufgesetzt werden kann, so dass der Bauteilkörper 14 mechanisch in der Haltevorrichtung 18 fixiert sein kann. Wenn eine seitliche und axiale mechanische Fixierung durch die Haltevorrichtung 18 und die Klemmabragungen 20 eine Bewegung des Bauteilkörpers 14 in allen drei Raumrichtungen sicher verhindert, so kann auch auf die Verklebung 22 verzichtet werden. In einem weiteren Schritt können die Aussparungen 44 in der Fixiervorrichtung 38 um die Anschlussdrähte 32 herum mit der Fixiermasse 50 ausgefüllt werden und die Verklebung 22 sowie die Fixiermasse 50 in den Aussparungen 44 können ausgehärtet werden, etwa durch Wärme, Licht und/oder Trocknung. Eine Masse der Fixiermasse 50 sollte dabei eine so geringe Gewichtskraft auf die Anschlussdrähte 32 erzeugen, dass diese nicht zu einer mechanischen Vorspannung der Anschlussdrähte 32 führt. Die Fixiermasse 50 sollte dabei hinsichtlich ihrer Viskosität derart eingestellt sein, dass sie während der Montage der Elektronikbauteilanordnung 10 nicht schwerkraftsbedingt aus den Aussparungen 44 läuft. Dies kann beispielsweise auch durch ein kurzes Vorvernetzen oder Voraushärten, etwa mit Licht (UV-Lichtquelle) und/oder Wärme (Wärmestrahler), erreicht werden. In einem weiteren Schritt werden die Kontaktgabeln 36 durch Zusammendrücken und/oder Hotstacking und/oder Widerstandsschweißen mit den Anschlussdrähten 32 fest kontaktiert. Hierbei können sich die relativ weichen Anschlussdrähte 32 den Positionen der Kontaktgabeln 36 fügen, d. h. sie können seitlich belastet und gebogen werden, wie in Fig. 3 gut erkennbar. Ein Biegemoment auf die Anschlussdrähte 32 erzeugt dabei eine Mittelspannung, die nur noch auf die Fixiermasse 50 bzw. die dadurch bereitgestellte Verklebung der Anschlussdrähte 32 in den Aussparungen 44 wirkt, aber nicht mehr auf ein Inneres des Bauteils 12 übertragen wird. Dadurch kann erreicht werden, dass eine Verformung und/oder Verbiegung der Anschlussdrähte 32 nicht bis zu den Terminals 30 bzw. den Paddle-Tabs geleitet wird, weshalb sich diese in einem mechanisch spannungsfreien Zustand befinden können, also ohne Mittelspannung. Durch eine verschwindende Mittelspannung kann die Schwingungsfestigkeit des Bauteils 12 maximiert werden.

Abschließend ist darauf hinzuweisen, dass Begriffe wie "aufweisend", "umfassend", etc. keine anderen Elemente ausschließen und Begriffe wie "eine" oder "ein" keine Vielzahl ausschließen.

Bezugszeichen in den Ansprüchen sind nicht als Einschränkung anzusehen.

## Patentansprüche

1. Elektronikbauteilanordnung (10), aufweisend:
ein elektronisches Bauteil (12) mit einem Bauteilkörper (14) und zwei Anschlussdrähten (32), welche von einer Seite (23) des Bauteilkörpers (14) abragen;
zwei Kontaktgabeln (36) zur elektrischen Kontaktierung jeweils eines Anschlussdrahtes (32);
wobei die Elektronikbauteilanordnung (10) eine Fixiervorrichtung (38) zur Fixierung der Anschlussdrähte (32) aufweist,
wobei die Fixiervorrichtung (38) zwischen den Kontaktgabeln (36) und dem Bauteilkörper (14) angeordnet ist,
wobei ein erstes Ende (40) der Fixiervorrichtung (38) auf einer Trägerplatte (16) befestigt ist und ein zweites Ende (42) der Fixiervorrichtung (38) von der Trägerplatte (16) abragt,
wobei an dem zweiten Ende (42) jeweils eine Aussparung (44) angeordnet ist, in welcher ein Anschlussdraht (32) aufgenommen und positionssicher fixiert ist, und wobei die beiden Kontaktgabeln (36) zur elektrischen Kontaktierung des jeweiligen Anschlussdrahtes (32) auf der Trägerplatte (16) parallel zueinander im Wesentlichen orthogonal von der Trägerplatte (16) abragen.

2. Elektronikbauteilanordnung (10) gemäß Anspruch 1
wobei ein Querschnitt der Aussparung (44) wesentlich größer als ein Querschnitt des Anschlussdrahtes (32) ist.

3. Elektronikbauteilanordnung (10) gemäß einem der Ansprüche 1 oder 2,
wobei ein Querschnitt der Aussparung (44) wenigstens doppelt so groß ist wie ein Querschnitt des Anschlussdrahtes (32).

4. Elektronikbauteilanordnung (10) gemäß einem der voranstehenden Ansprüche,
wobei zwei sich planparallel gegenüberliegende Begrenzungsflächen (46, 48) der Aussparung (44) wenigstens einen Abstand eines 1,3-fachen Wertes eines Durchmessers des Anschlussdrahtes (32) aufweisen.

5. Elektronikbauteilanordnung (10) gemäß einem der voranstehenden Ansprüche,
wobei die Fixiervorrichtung (38) aus Kunststoff besteht.

6. Elektronikbauteilanordnung (10) gemäß einem der voranstehenden Ansprüche,
wobei der Anschlussdraht (32) mit einer Fixiermasse (50) in der Aussparung (44) fixiert ist.

7. Elektronikbauteilanordnung (10) gemäß einem der voranstehenden Ansprüche,.
wobei die Aussparung (44) in Richtung einer Flächennormalen der Trägerplatte (16) offen ausgebildet ist.

8. Elektronikbauteilanordnung (10) gemäß einem der Ansprüche 1 bis 6,
wobei die Aussparung (44) als ringförmig geschlossene Durchgangsöffnung an dem zweiten Ende (42) der Fixiervorrichtung (38) ausgebildet ist.

9. Elektronikbauteilanordnung (10) gemäß einem der voranstehenden Ansprüche,
wobei das elektronische Bauteil (12) wenigstens zwei Anschlussdrähte (32) aufweist, welche jeweils von der gleichen Seite (23) des Bauteilkörpers (14) abragen, und
wobei die Fixiervorrichtung (38) zwei Aussparungen (44) aufweist, in welchen jeweils ein Anschlussdraht (32) aufgenommen ist.

10. Elektronikbauteilanordnung (10) gemäß einem der voranstehenden Ansprüche,
wobei das elektronische Bauteil (12) ein Elektrolytkondensator ist.

## Claims

1. Electronics component arrangement (10), having:
an electronic component (12) with a component body (14) and two connection wires (32) which project from one side (23) of the component body (14);
two contact forks (36) for electrically contacting in each case one connection wire (32);
wherein the electronics component arrangement (10) has a fixing apparatus (38) for fixing the connection wires (32) ,
wherein the fixing apparatus (38) is arranged between the contact forks (36) and the component body (14),
wherein a first end (40) of the fixing apparatus (38) is mounted on a carrier plate (16) and a second end (42) of the fixing apparatus (38) projects from the carrier plate (16) ,
wherein a cutout (44) in which a connection wire (32) is received and fixed in a positionally secure manner is respectively arranged at the second end (42),
and wherein the two contact forks (36) for electrically contacting the respective connection wire (32) on the carrier plate (16) project substantially orthogonally from the carrier plate (16) parallel to one another.

2. Electronics component arrangement (10) according to Claim 1,
wherein a cross section of the cutout (44) is substantially larger than a cross section of the connection wire (32).

3. Electronics component arrangement (10) according to either of Claims 1 and 2,
wherein a cross section of the cutout (44) is at least twice as large as a cross section of the connection wire (32) .

4. Electronics component arrangement (10) according to one of the preceding claims,
wherein two boundary surfaces (46, 48), which are situated opposite one another in a plane-parallel manner, of the cutout (44) are spaced apart at least by 1.3 times the value of a diameter of the connection wire (32).

5. Electronics component arrangement (10) according to one of the preceding claims,
wherein the fixing apparatus (38) consists of plastic.

6. Electronics component arrangement (10) according to one of the preceding claims,
wherein the connection wire (32) is fixed in the cutout (44) using a fixing compound (50).

7. Electronics component arrangement (10) according to one of the preceding claims,
wherein the cutout (44) is of open design in the direction of a surface normal of the carrier plate (16).

8. Electronics component arrangement (10) according to one of Claims 1 to 6,
wherein the cutout (44) is designed as an annularly closed passage opening at the second end (42) of the fixing apparatus (38).

9. Electronics component arrangement (10) according to one of the preceding claims, wherein the electronic component (12) has at least two connection wires (32) which each project from the same side (23) of the component body (14), and
wherein the fixing apparatus (38) has two cutouts (44), in each of which a connection wire (32) is received.

10. Electronics component arrangement (10) according to one of the preceding claims,
wherein the electronic component (12) is an electrolytic capacitor.

## Revendications

1. Ensemble à composant électronique (10), présentant :
un composant électronique (12) avec un corps de composant (14) et deux fils de raccordement (32) qui dépassent depuis un côté (23) du corps de composant (14) ;
deux fourches de contact (36) pour le contact électrique d'un fil de raccordement respectif (32) ;
l'ensemble à composant électronique (10) présentant un dispositif de fixation (38) pour la fixation des fils de raccordement (32),
le dispositif de fixation (38) étant disposé entre les fourches de contact (36) et le corps de composant (14),
une première extrémité (40) du dispositif de fixation (38) étant fixée sur une plaque de support (16) et une deuxième extrémité (42) du dispositif de fixation (38) dépassant de la plaque de support (16),
un évidement (44) étant à chaque fois disposé au niveau de la deuxième extrémité (42), dans lequel un fil de raccordement (32) est reçu et est fixé de manière sécurisée,
et les deux fourches de contact (36) pour le contact électrique du fil de raccordement respectif (32) sur la plaque de support (16) dépassant essentiellement perpendiculairement depuis la plaque de support (16) parallèlement l'une à l'autre.

2. Ensemble à composant électronique (10) selon la revendication 1,
dans lequel une section transversale de l'évidement (44) est sensiblement supérieure à une section transversale du fil de raccordement (32).

3. Ensemble à composant électronique (10) selon l'une quelconque des revendications 1 et 2,
dans lequel une section transversale de l'évidement (44) est au moins deux fois plus grande qu'une section transversale du fil de raccordement (32).

4. Ensemble à composant électronique (10) selon l'une quelconque des revendications précédentes,
dans lequel deux surfaces de limitation opposées l'une à l'autre de manière plan-parallèle (46, 48) de l'évidement (44) présentent au moins un espacement d'une valeur de 1,3 fois un diamètre du fil de raccordement (32).

5. Ensemble à composant électronique (10) selon l'une quelconque des revendications précédentes,
dans lequel le dispositif de fixation (38) se compose de plastique.

6. Ensemble à composant électronique (10) selon l'une quelconque des revendications précédentes,
dans lequel le fil de raccordement (32) est fixé dans l'évidement (44) avec une masse de fixation (50) .

7. Ensemble à composant électronique (10) selon l'une quelconque des revendications précédentes,
dans lequel l'évidement (44) est réalisé sous forme ouverte dans la direction d'une normale à la surface de la plaque de support (16).

8. Ensemble à composant électronique (10) selon l'une quelconque des revendications 1 à 6,
dans lequel l'évidement (44) est réalisé sous forme d'ouverture traversante fermée sous forme annulaire au niveau de la deuxième extrémité (42) du dispositif de fixation (38).

9. Ensemble à composant électronique (10) selon l'une quelconque des revendications précédentes,
dans lequel le composant électronique (12) présente au moins deux fils de raccordement (32), qui dépassent chacun depuis le même côté (23) du corps de composant (14), et
dans lequel le dispositif de fixation (38) présente deux évidements (44) dans lesquels est à chaque fois reçu un fil de raccordement (32).

10. Ensemble à composant électronique (10) selon l'une quelconque des revendications précédentes,
dans lequel le composant électronique (12) est un condensateur électrolytique.
